# EUROPEAN PATENT SPECIFICATION

(11) **EP 3 211 123 B1**
(45) Date of publication and mention of the grant of the patent: **09.01.2019**
(21) Application number: 17157426.2
(22) Date of filing: 22.02.2017
(51) Int. Cl.: C23C 18/18, C23C 18/16, C23C 18/38

(54) **HORIZONTAL METHOD OF ELECTROLESS METAL PLATING OF SUBSTRATES WITH IONIC CATALYSTS**
HORIZONTALES VERFAHREN ZUR STROMLOSEN METALLGALVANISIERUNG VON SUBSTRATEN MIT IONISCHEN KATALYSATOREN
PROCÉDÉ HORIZONTAL DE DÉPÔT MÉTALLIQUE AUTOCATALYTIQUE DE SUBSTRATS AU MOYEN DE CATALYSEURS IONIQUES

(30) Priority: 29.02.2016 US 201615056196
(43) Date of publication of application: 30.08.2017
(73) Proprietor: Rohm and Haas Electronic Materials LLC, Marlborough, MA 01752 (US)
(72) Inventor: LIU, Feng, Marlborough, MA 01752 (US); RZEZNIK, Maria, Marlborough, MA 01752 (US)
(74) Representative: Houghton, Mark Phillip

(56) References cited:
- EP-A1- 2 845 922
- EP-A2- 2 465 974
- DE-A1- 3 435 898
- US-A1- 2014 242 287
- US-A1- 2015 307 991

## Description

### Field of the Invention

The present invention is directed to horizontal methods of electroless metal plating of substrates with ionic catalysts to maintain or improve the performance of the catalysts during electroless metal plating and provide good metal adhesion to the substrates. More specifically, the present invention is directed to horizontal methods of electroless metal plating of substrates with ionic catalysts to maintain or improve the performance of the catalysts during electroless metal plating and provides good metal adhesion to the substrates by reducing or inhibiting undesired foaming and scum formation during the horizontal electroless metal plating process.

### Background of the Invention

Electroless plating is one of the most important metallization technologies in the printed circuit board industry. In recent years high density printed circuit boards such as those with microvias and through-holes are more frequently processed in a horizontal process mode with ionic catalysts. This is in part due to the more beneficial fluid dynamics allowing metallization chemicals to reach the bottom of microvias, especially those microvias with high aspect ratios of 1:1 and higher.

Catalysts based on ionic solutions have several important advantages over the colloidal catalysts in horizontal plating systems. The ionic catalyst complexes have intrinsically superior stability to oxidizing environments, such as the high agitation typically found in horizontal conveyorized equipment, due to the absence of extraneous metal ions such as tin (II) ions. Additionally, the ionic catalyst complexes enable penetration and surface activation of high aspect ratio microvia bottoms while maintaining wide operating parameters with ease of process control. Finally, these catalysts provide the reduced residual conductivity necessary for fine line technology found in these complex designs. For high density interconnects horizontal processing is a preferred technology given that a conveyorized system can more readily handle thin core processing. Additionally, the improved solution flow can readily meet the uniformity requirements of complex microstructures on both sides of printed circuit board panels through consistent catalyst application and chemical treatment. However, the high solution agitation in horizontal systems causes surfactant-containing solutions to foam and potentially leads to air bubbles and surfactant molecules trapped inside the bottom of the microvia, resulting in a reliability issue.

Surfactants such as alkyl phenoxy polyethoxyethanols, polyoxyethylene polymers and linear alkylbenzene sulfonate have been used as wetting agents to treat the circuit board for better adsorption of ionic catalysts as well as colloidal catalysts. In the horizontal process plating mode, these aqueous surfactant solutions foam when air is bubbled through them. When they are used as a pre-dip solution prior to the catalyst step, surfactants and foam can be dragged into the catalyst bath. Ionic catalysts such as ionic palladium catalysts include palladium ions and organic chelators. Ionic catalyst baths also foam in horizontal process mode due to the oligomer or polymer nature of the catalyst moiety. The pre-dip surfactant dragged into the ionic catalyst bath module may make the catalyst foam dissipate slower and stay longer, resulting in scum formation on the catalyst solution surface. Such foaming and scum formation can result in loss of the catalyst from the catalyst bath. In addition, the foam and scum can plug microvias and through-holes resulting in defective circuit boards. US2014/242287 discloses a solution useful for a catalyst of a process for electroless plating a metal on non-conductive surface, including a precious metal nanoparticle and a polymer polymerized from at least two monomers, (1) a monomer having two or more carboxyl groups or carboxyl acid salt groups and (2) a monomer which has π electron-available features. DE3435898 discloses o plastic substrates for anchoring metal coatings by means of wet metallisation after prior surface treatment with acidic, aromatic radical-containing compounds which are substituted by one or more hydroxyl groups and/or by derivatives thereof, where at least the area of the plastic substrate intended for metallisation comprises a copolymer P built up from at least 1 % by weight (based on the copolymer P) of acrylamide. US2015/307991 discloses catalysts including nanoparticles of palladium metal and cellulose derivatives, which are used in electroless metal plating and are free of tin. Accordingly, there is a need for a pre-dip formulation which reduces or inhibits foam and scum formation and at the same time enables good adsorption of the catalyst to substrate surfaces for electroless metallization.

### Summary of the Invention

The invention is set out in accordance with the appended claims. Horizontal methods of electroless plating substrates include: cleaning and conditioning the substrate; microetching the substrate; providing an aqueous acid pre-dip composition consisting of one or more dihydroxybenzoic acid compounds chosen from 3,5-dihydroxybenzoic acid, 2,4-dihydroxybenzoic acid, 2,5-dihydroxybenzoic acid, 2,6-dihydroxybenzoic acid, 2,4-dihydroxy-6-methylbenzoic acid, 2,3-dihydroxybenzoic acid, 3,4-dihydroxybenzoic acid and sodium salts thereof; water, and one or more compounds chosen from alkali metal hydroxides and inorganic acids to maintain a pH of the aqueous acid pre-dip composition from 2-4; applying the aqueous acid pre-dip composition to the substrate; applying an ionic catalyst to the substrate having an alkaline pH; wherein the ionic catalyst comprises complexes of metal ions with one or more heterocyclic nitrogen compounds, wherein the metal ions are chosen from palladium, platinum or gold, and wherein the ionic catalysts are free of tin, tin ions and antioxidants; applying a reducing agent to the substrate with the ionic catalyst to reduce the metal ions of the ionic catalyst to a metallic state; and applying an electroless copper or copper alloy plating bath to the substrate with the ionic catalyst comprising metal ions reduced to the metallic state to plate the substrate with copper or copper alloy.

The pre-dips of the horizontal methods reduce or prevent foaming and scum formation of the ionic catalyst solution during the horizontal electroless metal plating process, thus preventing loss of the ionic catalyst. Scum can contaminate and cause the loss of catalyst. In addition, the foam and scum can block through-holes and vias, thus inhibiting metallization of such features. During application of the ionic catalyst to the substrate vigorous solution agitation is preferably applied to the catalyst bath and substrate to encourage the ionic catalyst to penetrate into any through-holes and vias in the substrate. In general, ionic catalysts for printed circuit board metallization are prone to foaming, thus vigorous agitation exacerbates foaming. The pre-dip reduces or prevents the undesired foaming and subsequent scum formation in the catalyst bath. Further, surfactants which are included in many conventional pre-dip formulations for purposes of improving adsorption of ionic catalysts to substrates are excluded from the pre-dips of the horizontal method. Such surfactants typically foam or induce foaming. In addition to reducing or inhibiting foaming, pre-dips also enable good adsorption of the ionic catalyst to the substrate. Good adsorption of the ionic catalyst is imperative to achieve good electroless metal plating on the substrate as well as in any features in the substrate such as through-holes and vias.

### Brief Description of the Drawings

Figure 1 is a plot of backlight performance of electroless copper plating of through-holes for a plurality of substrates where an aqueous acid pre-dip solution containing 2,4-dihydroxybenzoic acid or ascorbic acid were used to prepare the through-holes.
Figure 2 is a plot of backlight performance of electroless copper plating of through-holes for a plurality of substrates where an aqueous acid pre-dip solution containing tannic acid was used to prepare the through-holes.

### Detailed Description of the Invention

As used throughout this specification, the abbreviations given below have the following meanings, unless the context clearly indicates otherwise: g = gram; mg = milligram; mL = milliliter; L = liter; cm = centimeter; mm = millimeter; ppm = parts per million = mg/L; mol = moles; °C = degrees Centigrade; g/L = grams per liter; DI = deionized; wt% = percent by weight; T_{g} = glass transition temperature; halide = chlorine, bromine and fluorine.

The terms "plating" and "deposition" are used interchangeably throughout this specification. The term feature means structure on the surface of a substrate or in the substrate such as a through-hole, via or microvia. The term "via" includes any size via found in printed circuit boards including microvias. The term "horizontal method" means that panels for printed circuit boards are processed in a horizontal position on conveyors while passing through the various solutions including the plating solution during an electroless metallization process and solution agitation is typically provided by flood/spray bars and is more vigorous than rack agitation in a vertical metallization process. The term "vertical method" means the panels for printed circuit boards are clamped on racks and dipped vertically into solutions in preparation for metallization including the metal plating solution. The term "immediate" or "immediately" means that there are no intervening steps. All amounts are percent by weight, unless otherwise noted. The indefinite article "a" and "an" refers to the singular as well as the plural. All numerical ranges are inclusive and combinable in any order except where it is logical that such numerical ranges are constrained to add up to 100%.

The present invention is directed to horizontal methods of electroless metal plating where an aqueous acid pre-dip has dihydroxybenzoic acids such as 3,5-dihydroxybenzoic acid, 2,4-dihydroxybenzoic acid, 2,5-dihydroxybenzoic acid, 2,6-dihydroxybenzoic acid, 2,4-dihydroxy-6-methylbenzoic acid, 2,3-dihydroxybenzoic acid, 3,4-dihydroxybenzoic acid; and sodium salts thereof. Such compounds are included in the aqueous acid pre-dip in amounts of 5 ppm to 30 g/L, preferably from 10 ppm to 20 g/L, more preferably from 20 ppm to 10 g/L, and even more preferably from 30 ppm to 3 g/L. The aqueous acid pre-dip solution includes one or more buffering agents. Such buffering agents are chosen from alkali metal hydroxides such as sodium or potassium hydroxide and inorganic acids such as sulfuric acid, nitric acid or hydrochloric acid. Preferably nitric acid is the acid used. Buffers included in the aqueous acid pre-dip exclude acids and bases which may interfere with the performance of the ionic catalysts. Buffers are included in the pre-dip in amounts to maintain a pH from 2 to 4.

In addition to excluding acids and bases from the aqueous acid pre-dip solution which may interfere with the ionic catalyst stability and performance, surfactants are also excluded. The aqueous acid pre-dip solution is composed of one or more compounds of formula (I), water and optionally one or more buffers. Preferably, the aqueous acid pre-dip solution is composed of one or more dihydroxybenzoic acid compounds, water and one or more buffers. Preferably the buffers are sodium hydroxide and nitric acid in amounts to provide the desired acid pH.

The aqueous acid pre-dip solution is applied to the substrate subsequent to micro-etching the substrate and any features in the substrate. The pre-dip may be applied by spraying the substrate or by immersing the substrate in the pre-dip. The pre-dip is maintained at a temperature from room temperature to 60 °C, preferably from room temperature to 30 °C.

The substrate remains in contact with the aqueous acid pre-dip solution for 30 seconds to 3 minutes prior to applying the ionic catalyst. During the time the substrate is in contact with the aqueous acid pre-dip solution, the pre-dip solution is agitated to encourage the pre-dip solution to enter and concentrate in and throughout substrate features such as through-holes and vias and to ensure uniform distribution of the pre-dip across the substrate. Agitation may be done using any suitable conventional apparatus used for agitating solutions such as flood bars and spray bars. Rates of agitation can vary depending on the size of the substrate and the number of features on the substrate. Foam generation is inhibited or is insignificant.

The substrate with the aqueous acid pre-dip is then contacted with an aqueous ionic catalyst solution without any rinse step between application of the pre-dip solution to the substrate and application of the ionic catalyst to the substrate. Agitation is continued at the previous rate or may be increased or decreased as needed to encourage the catalyst to uniformly distribute across the substrate and in the features. Foam generation is inhibited or insignificant such that the amount of scum formed, if any, does not cause loss of catalyst during electroless metal plating.

Ionic catalysts include a complexing agent or chelating agent and metal ions. Preferably the ionic catalysts are aqueous and alkaline. Aqueous alkaline catalyst solutions preferably include complexes of metal ions chosen from gold, platinum, palladium, and one or more heterocyclic nitrogen compounds as complexing or chelating agents. Preferably the heterocyclic nitrogen compounds are chosen from pyridine, pyrimidine and pyrazine derivatives.

Pyridine derivatives include but are not limited to 4-dimethylaminopyridine, 4-aminopyridine, 2-aminopyridine, 4-(methylamino)pyridine, 2-(methylamino)pyridine, 2-amino-4,6-dimethylpyridine, 2-dimethylamino-4,6-dimethylpyridine, 4-diethylaminopyridine, 2-(pyridin-3-yl)-acetic acid, 2-amino-3-(pyridin-3-yl)-propionic acid, 2-amino-3-(pyridin-2-yl)-propionic acid, 3-(pyridin-3-yl)-acrylic acid, 3-(4-methylpyridin-2-yl)acrylic acid and 3-(pyridin-3-yl)-acrylamide.

Pyrimidine derivatives include but are not limited to uracil, barbituric acid, orotic acid, thymine, 2-aminopyrimidine, 6-hydroxy-2,4-dimethylpyrimidine, 6-methyluracil, 2-hydroxypyrimidine, 4,6-dichloropyrimidine, 2,4-dimethoxypyrimidine, 2-amino-4,6-dimethylpyrimidine, 2-hydroxy-4,6-dimethylpyrimidine and 6-methylisocytosine.

Pyrazine derivatives include but are not limited to 2,6-dimethylpyrazine, 2,3-dimethylpyrazine, 2,5-dimethylpyrazine, 2,3,5-trimethylpyraizine, 2-acetylpyrazine, aminopyrazine, ethylpyrazine, methoxypyrazine, and 2-(2'-hydroxyethyl)pyrazine.

Sources of metal ions include any of the conventional water soluble metal salts of palladium, gold and platinum known in the art and literature. One type of catalytic metal ion may be used or mixtures of two or more catalytic metal ions may be used. Such salts are included to provide metal ions in amounts of 20 ppm to 2000 ppm, preferably from 25 ppm to 500 ppm. Palladium salts include, but are not limited to palladium chloride, palladium acetate, palladium potassium chloride, palladium sodium chloride, sodium tetrachloropalladate, palladium sulfate and palladium nitrate. Gold salts include, but are not limited to gold cyanide, gold trichloride, gold tribromide, potassium gold chloride, potassium gold cyanide, sodium gold chloride and sodium gold cyanide. Platinum salts include, but are not limited to platinum chloride and platinum sulfate. Preferably the metal ions are palladium and gold ions. More preferably the metal ions are palladium.

The amount of heterocyclic complexing or chelating agents and one or more metal ions included in the aqueous alkaline catalyst solutions are such that a molar ratio of complexing or chelating agents to metal ions is from 1:1 to 4:1, preferably from 1:1 to 2:1. The pH of the aqueous catalyst solution is adjusted to an alkaline pH with salts such as sodium tetraborate, sodium carbonate, sodium bicarbonate, sodium phosphate or alkali metal hydroxides such as potassium or sodium hydroxide or mixtures thereof. The pH range of the aqueous alkaline catalyst solution is from 8 and greater, preferably from 9 and greater, more preferably from 9 to 13, most preferably from 9 to 12. The aqueous alkaline catalysts are free of tin, tin ions and antioxidants.

Following application of the catalyst to the substrate and prior to metallization one or more reducing agents are applied to the catalyzed substrate to reduce the metal ions to their metallic state. Conventional reducing agents known to reduce metal ions to metal may be used. Such reducing agents include, but are not limited to dimethylamine borane, sodium borohydride, ascorbic acid, iso-ascorbic acid, sodium hypophosphite, hydrazine hydrate, formic acid and formaldehyde. Preferably the reducing agent is sodium hypophosphite and dimethylamine borane. More preferably the reducing agent is dimethylamine borane. Reducing agents are included in amounts to reduce substantially all of the metal ions to metal. Such amounts are generally conventional amounts and are well known by those of skill in the art.

The horizontal metallization method with the aqueous acid pre-dip of the present invention can be used to electrolessly metal plate various substrates such as semiconductors, metal-clad and unclad substrates such as printed circuit boards. Such metal-clad and unclad printed circuit boards may include thermosetting resins, thermoplastic resins and combinations thereof, including fiber, such as fiberglass, and impregnated embodiments of the foregoing. Preferably the substrate is a metal-clad printed circuit or wiring board.

The horizontal metallization method of the present invention can be used to electrolessly metal plate features of the substrates such as through-holes and vias. The conventional European Backlight process can be used to determine the performance of metal plating the walls of through-hole and vias. In the European Backlight process the substrate is cross-sectioned nearest to the centers of the through-holes or vias as possible to expose the metal plated walls. The cross-sections are taken from each substrate to determine the through-hole or via wall coverage. The cross-sections are placed under a conventional optical microscope with a light source behind the samples. The quality of the metal deposits is determined by the amount of light visible under the microscope that is transmitted through the sample. Transmitted light is only visible in areas of the plated through-holes or vias where there is incomplete electroless metal coverage. If no light is transmitted and the section appears completely black, it is rated a 5 on the European Backlight scale indicating complete metal coverage on the wall. If light passes through the entire section without any dark areas, this indicates that there is very little to no metal deposition on the wall and the section is rated 0. If sections have some dark regions as well as light regions, there is partial metal plating on the walls and samples are rated between 0 and 5.

The horizontal method of the present invention with the aqueous acid pre-dip containing the benzoic acid derivatives enables an average European Backlight value of greater than 4 to 5, preferably 4.3 to 5, more preferably from 4.5 to 5. Within the more preferred range an average European Backlight value from 4.6 to 4.7 is typical. In the electroless metal plating industry an average European Backlight value of greater than 4 is desired and an average value of 4.5 to 5 is preferred.

Thermoplastic resins include, but are not limited to acetal resins, acrylics, such as methyl acrylate, cellulosic resins, such as ethyl acetate, cellulose propionate, cellulose acetate butyrate and cellulose nitrate, polyethers, nylon, polyethylene, polystyrene, styrene blends, such as acrylonitrile styrene and copolymers and acrylonitrile-butadiene styrene copolymers, polycarbonates, polychlorotrifluoroethylene, and vinylpolymers and copolymers, such as vinyl acetate, vinyl alcohol, vinyl butyral, vinyl chloride, vinyl chloride-acetate copolymer, vinylidene chloride and vinyl formal.

Thermosetting resins include, but are not limited to allyl phthalate, furane, melamine-formaldehyde, phenol-formaldehyde and phenol-furfural copolymers, alone or compounded with butadiene acrylonitrile copolymers or acrylonitrile-butadiene-styrene copolymers, polyacrylic esters, silicones, urea formaldehydes, epoxy resins, allyl resins, glyceryl phthalates and polyesters.

The horizontal method can be used to plate substrates with both low and high T_{g} resins. Low T_{g} resins have a T_{g} below 160° C and high T_{g} resins have a T_{g} of 160° C and above. Typically high T_{g} resins have a T_{g} of 160° C to 280° C or such as from 170° C to 240° C. High T_{g} polymer resins include, but are not limited to, polytetrafluoroethylene (PTFE) and polytetrafluoroethylene blends. Such blends include, for example, PTFE with polypheneylene oxides and cyanate esters. Other classes of polymer resins which include resins with a high Tg include, but are not limited to, epoxy resins, such as difunctional and multifunctional epoxy resins, bimaleimide/triazine and epoxy resins (BT epoxy), epoxy/polyphenylene oxide resins, acrylonitrile butadienestyrene, polycarbonates (PC), polyphenylene oxides (PPO), polypheneylene ethers (PPE), polyphenylene sulfides (PPS), polysulfones (PS), polyamides, polyesters such as polyethyleneterephthalate (PET) and polybutyleneterephthalate (PBT), polyetherketones (PEEK), liquid crystal polymers, polyurethanes, polyetherimides, epoxies and composites thereof.

The horizontal method with the aqueous acid pre-dip solution can be used with conventional aqueous alkaline electroless metal plating baths. While it is envisioned that the catalysts may be used to electrolessly deposit any metal which may be electrolessly plated, preferably, the metal is chosen from copper, copper alloys, nickel or nickel alloys. More preferably the metal is chosen from copper and copper alloys, most preferably copper is the metal. An example of a commercially available electroless copper plating bath is CIRCUPOSIT™ 6550 Electroless Copper bath (available from Dow Advanced Materials, Marlborough, MA).

Typically sources of copper ions include, but are not limited to water soluble halides, nitrates, acetates, sulfates and other organic and inorganic salts of copper. Mixtures of one or more of such copper salts may be used to provide copper ions. Examples include copper sulfate, such as copper sulfate pentahydrate, copper chloride, copper nitrate, copper hydroxide and copper sulfamate. Conventional amounts of copper salts may be used in the compositions. In general copper ion concentrations in the composition may range from 0.5 g/L to 30 g/L.

One or more alloying metals also may be included in the electroless compositions. Such alloying metals include, but are not limited to nickel and tin. Examples of copper alloys include copper/nickel and copper/tin. Typically the copper alloy is copper/nickel.

Sources of nickel ions for nickel and nickel alloy electroless baths may include one or more conventional water soluble salts of nickel. Sources of nickel ions include, but are not limited to, nickel sulfates and nickel halides. Sources of nickel ions may be included in the electroless alloying compositions in conventional amounts. Typically sources of nickel ions are included in amounts of 0.5 g/L to 10 g/L.

Preferably, the substrate to be metal plated is a metal-clad substrate with dielectric material and a plurality of through-holes, vias or combinations thereof such as a printed circuit board. The boards are rinsed with water and cleaned and degreased followed by desmearing the through-hole walls or vias. Typically prepping or softening the dielectric or desmearing of the through-holes or vias begins with application of a solvent swell.

Any conventional solvent swell can be used. The specific type can vary depending on the type of dielectric material. Examples of dielectrics are disclosed above. Minor experimentation can be done to determine which solvent swell is suitable for a particular dielectric material. The T_{g} of the dielectric often determines the type of solvent swell to be used. Solvent swells include, but are not limited to glycol ethers and their associated ether acetates. Conventional amounts of glycol ethers and their associated ether acetates can be used. Examples of commercially available solvent swells are CIRCUPOSIT™ Conditioner 3302, CIRCUPOSIT™ Hole Prep 3303 and CIRCUPOSIT™ Hole Prep 4120 solutions (available from Dow Advanced Materials).

After the solvent swell, optionally, a promoter is applied. Conventional promoters can be used. Such promoters include but are not limited to sulfuric acid, chromic acid, alkaline permanganate or plasma etching. Typically alkaline permanganate is used as the promoter. Examples of commercially available promoters are CIRCUPOSIT™ Promoter 4130 and CIRCUPOSIT™ MLB Promoter 3308 solutions (available from Dow Advanced Materials). Optionally, the substrate and through-holes or vias are rinsed with water.

A neutralizer is then applied to neutralize any residues left by the promoter. Conventional neutralizers can be used. Typically the neutralizer is an aqueous acidic solution containing one or more amines or a solution of 3wt% to 25wt% hydrogen peroxide and 3wt% sulfuric acid. An example of a commercially available neutralizer is CIRCUPOSIT™ MLB Neutralizer 216-5 (available from Dow Advanced Materials). Optionally, the substrate and through-holes or vias are rinsed with water and then dried.

After neutralizing a conditioner is then applied. An acid or alkaline conditioner is applied when plating through-holes or vias or a substrate including both types of features. Conventional conditioners can be used. Such conditioners include one or more cationic surfactants, non-ionic surfactants, complexing agents and pH adjusters or buffers. Examples of commercially available acid conditioners are CIRCUPOSIT™ Conditioners 3320A and 3327 solutions (available from Dow Advanced Materials). Suitable alkaline conditioners include, but are not limited to aqueous alkaline surfactant solutions containing one or more quaternary amines and polyamines. Examples of commercially available alkaline surfactants are CIRCUPOSIT™ Conditioner 231, 3325, 813 and 860 formulations. Optionally, the substrate and through-holes are rinsed with water.

Conditioning is then preferably immediately followed by micro-etching. Conventional micro-etching compositions can be used. Micro-etching is designed to provide a micro-roughened metal surface on exposed metal (e.g., innerlayers and surface etch) to enhance subsequent adhesion of plated electroless metal and later electroplate. Micro-etches include, but are not limited to 60 g/L to 120 g/L sodium persulfate or sodium or potassium oxymonopersulfate and sulfuric acid (2%) mixture, or generic sulfuric acid/hydrogen peroxide. Examples of commercially available micro-etching compositions are CIRCUPOSIT™ Microetch 3330 Etch solution and PREPOSIT™ 748 Etch solution (both available from Dow Advanced Materials). Optionally, the substrate is rinsed with water.

A pre-dip of the present invention is then applied after micro-etching, preferably immediately after micro-etching. The aqueous pre-dip solutions are described above. There is no water rinse subsequent to application of the pre-dip solution and prior to the application of the ionic catalyst. The pre-dip temperature is from room temperature to 60 °C, preferably from room temperature to 30 °C.

The ionic catalyst is then applied to the substrate without any intervening method step. An example of a commercially available ionic catalyst is CIRCUPOSIT™ 6530 Catalyst (available from Dow Advanced Materials). Application can be done by conventional methods used in the art, such as immersing the substrate in a solution of the catalyst or by spraying using conventional apparatus. Catalyst dwell time can range from 25 seconds to 120 seconds for horizontal equipment. The catalysts can be applied at temperatures from room temperature to 80° C, preferably from 30° C to 60° C. The substrate and through-holes and any vias are rinsed after application of the catalyst and before the subsequent method step.

The reducing solution is then applied to the substrate to reduce the metal ions of the catalyst to their metallic state. The reducing solution can be applied by immersing the substrate into the reducing solution or spraying the reducing solution onto the substrate. The temperature of the solution can range from room temperature to 65° C, preferably from 30° C to 55° C. Contact time between the reducing solution and the catalyzed substrate can range from 30 seconds to 2 minutes before application of the electroless metal plating bath.

The substrate and walls of the through-holes and vias are then electrolessly plated with metal, such as copper, copper alloy, nickel or nickel alloy using an electroless bath. Preferably copper is plated on the walls of the through-holes and vias. Plating times and temperatures may be conventional. Typically metal deposition is done at temperatures of 20° C to 80°, more typically from 30° C to 60° C. The substrate may be immersed in the electroless plating bath or the electroless bath may be sprayed onto the substrate. Typically, electroless plating may be done for 5 minutes to 30 minutes; however, plating times may vary depending on the thickness of the metal desired. Plating is done in an alkaline environment with a formaldehyde or other reducing agent such as a glyoxylic acid based reducer. Typically the pH of the plating solution is 10 and higher, preferably the pH is 11 and greater, more preferably the pH is from 12 to 13.5, most preferably the pH is from 12.5 to 13.5.

Optionally anti-tarnish can be applied to the metal. Conventional anti-tarnish compositions may be used. An example of anti-tarnish is ANTI TARNISH™ 7130 solution (available from Dow Advanced Materials). The substrate can optionally be rinsed with water and then the substrates can be dried.

Further processing can include conventional processing by photoimaging and further metal deposition on the substrates such as electrolytic metal deposition of, for example, copper, copper alloys, tin and tin alloys.

The following examples are included to further illustrate the invention but are not intended to limit the scope of the invention.

### Example 1

### Foam Height Comparison of 3,5-Dihydroxybenzoic Acid Based Pre-Dip and Dodecylbenzene Sulfonate Pre-dip Aqueous Solution

A one liter alkaline aqueous solution of 200 ppm CIRCUPOSIT™ 6530 ionic palladium catalyst was prepared as a working bath. 200 mL of the catalyst solution was added to two one liter glass beakers. 10 ppm of 3,5-dihydroxybenzoic acid pre-dip solution was added to one beaker with stir bar mixing. Nitric acid and sodium hydroxide were added to the 3,5-dihydroxybenzoic acid solution to provide a pH of 2. This solution was then added to the catalyst solution. 10 ppm sodium dodecylbenzene sulfonate anionic surfactant pre-dip solution was added to the second beaker. The addition of the pre-dip solution to the catalyst bath simulated the horizontal process of dragging of pre-dip solutions to the catalyst without a water rinse.

Purged air from a facility compressed air outlet connected to a glass tube through plastic tubing was applied at 2 liters/minute for 20 minutes to each solution with the catalyst and pre-dip to induce bubbling of the solutions to simulate the agitation typical of horizontal electroless metal plating processes. After 20 minutes the air was stopped and foam heights in each solution were immediately measured with a conventional centimeter calibrated ruler adjacent to each beaker. The solution which included 3,5-dihydroxybenzoic acid and the ionic catalyst had a foam height of 7 cm. In contrast, the solution which included the sodium dodecylbenzene sulfonate and ionic catalyst had a foam height of 13 cm. After 5 minutes of idling, the foam heights were measured again. The solution which included the 3,5-dihydroxybenzoic acid and the ionic catalyst had a foam height of 0.5 cm. In contrast, the solution which included the sodium dodecylbenzene sulfonate and ionic catalyst had a foam height of 6 cm. The results showed that the solution containing the 3,5-dihydroxybenzoic acid significantly reduced the amount of foam formation in the ionic catalyst solution in contrast to the solution which included the dodecylbenzene sulfonate.

### Example 2

### Plating Performance of Pre-Dip Solutions Containing 2,4-Dihydroxybenzoic Acid and Ascorbic Acid

Two pre-dip solutions were prepared. One solution was prepared by adding 2.5 g/L 2,4-dihydroxybenzoic acid to DI water. The second solution was prepared by adding 3 g/L ascorbic acid to DI water. The acid concentration in each solution was 0.016 mol/L. The pH of each solution was adjusted to 2 with dilute aqueous solution of sodium hydroxide and nitric acid. Two each of the following copper-clad epoxy resin laminates containing a plurality of through-holes were provided: TUC-662 from Taiwan Union Technology Corporation, SY-1141 from Shengyi Technology, NPGN-150 from Nanya Plastics, 370HR from Isola and EM-355 from Elite Material, Co., Ltd. The thickness of each laminate was 2 mm and the diameter of the through-holes was 1 mm. Each laminate was treated with the aqueous acid pre-dip solution containing 2,4-dihydroxybenzoic acid or the aqueous acid pre-dip containing ascorbic acid. Each laminate was prepared and plated with electroless copper according to the following method:
1. Each copper-clad laminate was desmeared by applying CIRCUPOSIT™ 211 sweller, CIRCUPOSIT™ 213 permanganate oxidizer and sulfuric acid/hydrogen peroxide neutralizer baths;
2. The laminates were then conditioned by immersing in an aqueous conditioner solution of 4% CIRCUPOSIT™ Conditioner-Cleaner 231 which contained a cationic surfactant, non-ionic surfactant and buffer at 40 °C for 2 minutes, then each laminate was rinsed with flowing tap water for 2 minutes;
3. The laminates were then immersed in sulfuric acid and sodium persulfate based PREPOSIT™ 748 Etch solution at room temperature for 1.5 minutes to micro-etch the through-holes of the laminates and then rinsed with flowing DI water for 2 minutes;
4. Each laminate was immersed in either the pre-dip which included 2,4-dihydroxybenzoic acid or ascorbic acid at room temperature for 45 seconds, no water rinse was done immediately after the application of the pre-dip solutions and before the subsequent step. No foaming was observed for either pre-dip;
5. Each laminate was then immersed into an aqueous alkaline ionic catalyst solution of 200 ppm CIRCUPOSIT™ 6530 ionic palladium catalyst at 40 °C for 90 seconds, followed by 2 minutes of flowing tap water rinse;
6. The laminates were then immersed into a dimethylamine borane based CIRCUPOSIT™ 6540 reducer solution at 30 °C for 90 seconds to reduce palladium ions to palladium metal and then rinsed with flowing DI water for 1.5 minutes;
7. The activated laminates were immersed in CIRCUPOSIT™ 6550 Electroless Copper bath at 42 °C for 6 minutes to plate copper in the through-holes;
8. After copper plating the laminates were rinsed with flowing tap water for 4 minutes and then dried by air blowing.

Each laminate was cross-sectioned nearest to the centers of the through-holes as possible to expose the copper plated walls. The cross-sections were taken from each board to determine the through-hole wall coverage. The European Backlight Grading Scale was used. The cross-sections from each board were placed under a conventional optical microscope of 50X magnification with a light source behind the samples. The quality of the copper deposits was determined by the amount of light visible under the microscope that was transmitted through the sample. Transmitted light was only visible in areas of the plated through-holes where there was incomplete electroless copper coverage. If no light was transmitted and the section appeared completely black, it was rated a 5 on the backlight scale indicating complete copper coverage of the through-hole wall. If light passed through the entire section without any dark areas, this indicated that there was very little to no copper metal deposition on the wall and the section was rated 0. If sections had some dark regions as well as light regions, they were rated between 0 and 5. A minimum of ten through-holes was inspected and rated for each board.

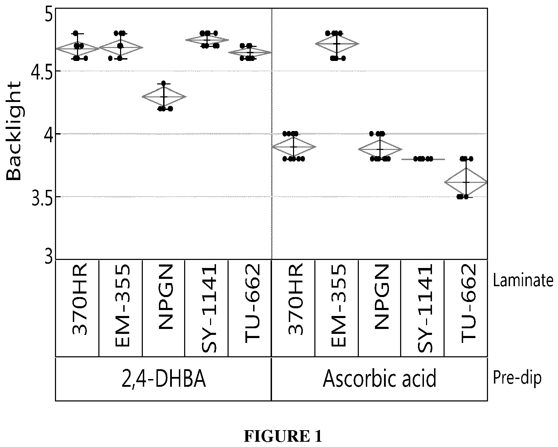

Figure 1 is a backlight performance plot comparing the electroless plating of through-holes of laminates treated with the pre-dip containing 2,4-dihydroxybenzoic acid (2,4-DHBA) to the laminates treated with the ascorbic acid pre-dip. The plot shows the range of backlight values for each laminate and the average backlight value for each laminate. The backlight values are also tallied in the tables below.

**Table 1**

| 2,4-DHBA | | |
|---|---|---|
| **Laminate** | **Backlight Range** | **Backlight Average** |
| 370HR | 4.6 to 4.8 | 4.7 |
| EM-355 | 4.6 to 4.8 | 4.7 |
| NPGN | 4.2 to 4.4 | 4.3 |
| SY-1141 | 4.70 to 4.8 | 4.7 |
| TU-662 | 4.6 to 4.75 | 4.7 |

**Table 2**

| Ascorbic Acid | | |
|---|---|---|
| **Laminate** | **Backlight Range** | **Backlight Average** |
| 370HR | 3.6 to 4 | 3.8 |
| EM-355 | 4.6 to 4.8 | 4.7 |
| NPGN | 3.7 to 4 | 3.8 |
| SY-1141 | 3.7 | 3.7 |
| TU-662 | 3.5 to 3.7 | 3.6 |

Except for the EM-355 laminate, the plating results showed that laminates treated with the 2,4-dihydroxybenzoic acid had significant improvement in through-hole plating coverage over the laminates treated with ascorbic acid. The results indicated that 2,4-dihydroxybenzoic acid had better adsorption on the through-holes than ascorbic acid.

### Example 3

### Tannic Acid as a Pre-Dip Solution for Electroless Copper Metallization

A pre-dip solution of tannic acid was prepared by adding 22 g/L tannic acid to DI water. The tannic acid concentration in the solution was 0.016 mol/L. The pH of the solution was adjusted to 2 with dilute aqueous solution of sodium hydroxide and nitric acid. The following copper-clad epoxy resin laminates containing a plurality of through-holes were provided: TUC-662 from Taiwan Union Technology Corporation, SY-1141 from Shengyi Technology, NPGN-150 from Nanya Plastics, 370HR from Isola and EM-355 from Elite Material, Co., Ltd.. Each laminate was treated with the aqueous tannic acid pre-dip solution. Some foaming was observed. Each laminate was prepared and plated with electroless copper according to the method in Example 2.

Each laminate was cross-sectioned nearest to the centers of the through-holes as possible to expose the copper plated walls. The cross-sections were taken from each board to determine the through-hole wall coverage. The European Backlight Grading Scale was used. The cross-sections from each board were placed under a conventional optical microscope of 50X magnification with a light source behind the samples. The quality of the copper deposits was determined by the amount of light visible under the microscope that was transmitted through the sample. Transmitted light was only visible in areas of the plated through-holes where there was incomplete electroless copper coverage. A minimum of ten through-holes was inspected and rated for each board. If no light was transmitted and the section appeared completely black, it was rated a 5 on the backlight scale indicating complete copper coverage of the through-hole wall. If light passed through the entire section without any dark areas, this indicated that there was very little to no copper metal deposition on the wall and the section was rated 0. If sections had some dark regions as well as light regions, they were rated between 0 and 5.

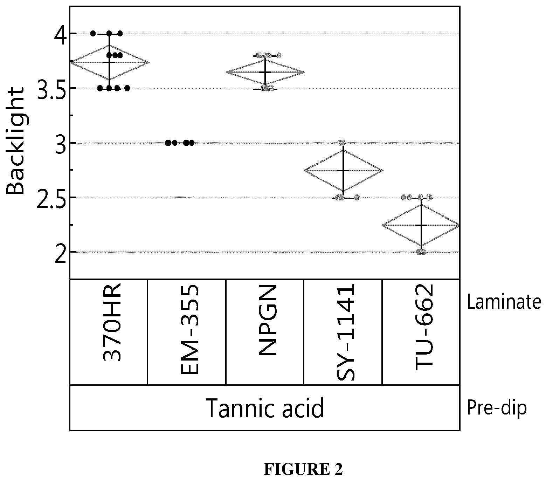

Figure 2 is a backlight performance plot showing the electroless plating of through-holes of the laminates treated with the pre-dip containing tannic acid. The plot shows the range of backlight values for each laminate and the average backlight value for each laminate. The backlight values are also tallied in the table below.

**Table 3**

| Tannic Acid | | |
|---|---|---|
| **Laminate** | **Backlight Range** | **Backlight Average** |
| 370HR | 3.5 to 4 | 3.7 |
| EM-355 | 3 | 3 |
| NPGN | 3.5 to 3.7 | 3.6 |
| SY-1141 | 2.5 to 3 | 2.7 |
| TU-662 | 2 to 2.5 | 2.7 |

The average backlight values for the electroless copper plating ranged from as low as 2.7 to only 3.7. The electroless copper plating using the tannic acid pre-dip compared to the pre-dip which included 2,4-dihydroxybenzoic acid was poor. The 2,4-dihydroxybenzoic acid had better adsorption on the through-hole walls than the tannic acid.

## Claims

1. A method of horizontal electroless plating a substrate comprising:
a) cleaning and conditioning the substrate; then,
b) microetching the substrate; then,
c) providing an aqueous acid pre-dip composition consisting of one or more dihydroxybenzoic acid compounds chosen from 3,5-dihydroxybenzoic acid, 2,4-dihydroxybenzoic acid, 2,5-dihydroxybenzoic acid, 2,6-dihydroxybenzoic acid, 2,4-dihydroxy-6-methylbenzoic acid, 2,3-dihydroxybenzoic acid, 3,4-dihydroxybenzoic acid and sodium salts thereof; water, and one or more compounds chosen from alkali metal hydroxides and inorganic acids to maintain a pH of the aqueous acid pre-dip composition from 2-4; then,
d) applying the aqueous acid pre-dip composition to the substrate; then,
e) applying an ionic catalyst to the substrate having an alkaline pH; wherein the ionic catalyst comprises complexes of metal ions with one or more heterocyclic nitrogen compounds, wherein the metal ions are chosen from palladium, platinum or gold, and wherein the ionic catalysts are free of tin, tin ions and antioxidants; followed by,
f) applying a reducing agent to the substrate with the ionic catalyst to reduce the metal ions of the ionic catalyst to a metallic state; and then,
g) applying an electroless copper or copper alloy plating bath to the substrate with the ionic catalyst comprising metal ions reduced to the metallic state to plate the substrate with copper or copper alloy.

2. The method of horizontal electroless plating of claim 1, wherein the one or more heterocyclic nitrogen compounds are one or more pyrazine derivatives chosen from 2,6-dimethylpyrazine, 2,3-dimethylpyrazine, 2,5-dimethylpyrazine, 2,3,5-trimethylpyraizine, 2-acetylpyrazine, aminopyrazine, ethylpyrazine, methoxypyrazine, 3,4-dimethylpyrazine and 2-(2'-hydroxyethyl)pyrazine.

3. The method of horizontal electroless plating of claim 1, wherein the one or more heterocyclic nitrogen compounds are one or more pyrimidine derivatives chosen from uracil, barbituric acid, orotic acid, thymine, 2-aminopyrimidine, 6-hydroxy-2,4-dimethylpyrimidine, 6-methyluracil, 2-hydroxypyrimidine, 4,6-dichloropyrimidine, 2,4-dimethoxypyrimidine, 2-amino-4,6-dimethylpyrimidine, 2-hydroxy-4,6-dimethylpyrimidine and 6-methylisocytosine.

4. The method of horizontal electroless plating of claim 1, wherein the one or more heterocyclic nitrogen compounds are one or more pyridine derivatives chosen from 4-dimethylaminopyridine, 4-aminopyridine, 2-aminopyridine, 4-(methylamino)pyridine, 2-(methylamino)pyridine, 2-amino-4,6-dimethylpyridine, 2-dimethylamino-4,6-dimethylpyridine, 4-diethylaminopyridine, 2-(pyridin-3-yl)-acetic acid, 2-amino-3-(pyridin-3-yl)-propionic acid, 2-amino-3-(pyridin-2-yl)-propionic acid, 3-(pyridin-3-yl)-acrylic acid, 3-(4-methylpyridin-2-yl)acrylic acid and 3-(pyridin-3-yl)-acrylamide

5. The method of horizontal electroless plating of claim 1, wherein the substrate comprises a plurality of through-holes, vias or combinations thereof.

6. The method of horizontal electroless plating of claim 1, wherein the inorganic acids are chosen from sulfuric acid or nitric acid.

## Patentansprüche

1. Ein Verfahren zum horizontalen stromlosen Plattieren eines Substrats, beinhaltend:
a) Reinigen und Konditionieren des Substrats; dann
b) Mikroätzen des Substrats; dann
c) Bereitstellen einer wässrigen sauren Vortauchzusammensetzung, bestehend aus Folgendem: einer oder mehreren Dihydroxybenzoesäureverbindungen, ausgewählt aus 3,5-Dihydroxybenzoesäure, 2,4-Dihydroxybenzoesäure, 2,5-Dihydroxybenzoesäure, 2,6-Dihydroxybenzoesäure, 2,4-Dihydroxy-6-methylbenzoesäure, 2,3-Dihydroxybenzoesäure, 3,4-Dihydroxybenzoesäure und Natriumsalzen davon; Wasser und einer oder mehreren Verbindungen, ausgewählt aus Alkalimetallhydroxiden und anorganischen Säuren, um einen pH-Wert der wässrigen sauren Vortauschzusammensetzung von 2-4 zu bewahren; dann
d) Anwenden der wässrigen sauren Vortauchzusammensetzung auf das Substrat; dann
e) Anwenden eines ionischen Katalysators mit einem alkalischen pH-Wert auf das Substrat; wobei der ionische Katalysator Komplexe von Metallionen mit einer oder mehreren heterocyclischen Stickstoffverbindungen beinhaltet, wobei die Metallionen aus Palladium, Platin oder Gold ausgewählt sind und wobei die ionischen Katalysatoren frei von Zinn, Zinnionen und Antioxidationsmitteln sind; gefolgt von
f) Anwenden eines Reduktionsmittels auf das Substrat mit dem ionischen Katalysator, um die Metallionen des ionischen Katalysators zu einem metallischen Zustand zu reduzieren; und dann
g) Anwenden eines stromlosen Kupfer- oder Kupferlegierungsplattierungsbads auf das Substrat mit dem ionischen Katalysator, der zu dem metallischen Zustand reduzierte Metallionen beinhaltet, zum Plattieren des Substrats mit Kupfer oder Kupferlegierung.

2. Verfahren zum horizontalen stromlosen Plattieren gemäß Anspruch 1, wobei die eine oder die mehreren heterocyclischen Stickstoffverbindungen ein oder mehrere Pyrazinderivate sind, ausgewählt aus 2,6-Dimethylpyrazin, 2,3-Dimethylpyrazin, 2,5-Dimethylpyrazin, 2,3,5-Trimethylpyrazin, 2-Acetylpyrazin, Aminopyrazin, Ethylpyrazin, Methoxypyrazin, 3,4-Dimethylpyrazin und 2-(2'-Hydroxyethyl)pyrazin.

3. Verfahren zum horizontalen stromlosen Plattieren gemäß Anspruch 1, wobei die eine oder die mehreren heterocyclischen Stickstoffverbindungen ein oder mehrere Pyrimidinderivate sind, ausgewählt aus Uracil, Barbitursäure, Orotsäure, Thymin, 2-Aminopyrimidin, 6-Hydroxy-2,4-dimethylpyrimidin, 6-Methyluracil, 2-Hydroxypyrimidin, 4,6-Dichlorpyrimidin, 2,4-Dimethoxypyrimidin, 2-Amino-4,6-dimethylpyrimidin, 2-Hydroxy-4,6-dimethylpyrimidin und 6-Methylisocytosin.

4. Verfahren zum horizontalen stromlosen Plattieren gemäß Anspruch 1, wobei die eine oder die mehreren heterocyclischen Stickstoffverbindungen ein oder mehrere Pyridinderivate sind, ausgewählt aus 4-Dimethylaminopyridin, 4-Aminopyridin, 2-Aminopyridin, 4-(Methylamino)pyridin, 2-(Methylamino)pyridin, 2-Amino-4,6-dimethylpyridin, 2-Dimethylamino-4,6-dimethylpyridin, 4-Diethylaminopyridin, 2-(Pyridin-3-yl)essigsäure, 2-Amino-3-(pyridin-3-yl)propionsäure, 2-Amino-3-(pyridin-2-yl)propionsäure, 3-(Pyridin-3-yl)acrylsäure, 3-(4-Methylpyridin-2-yl)acrylsäure und 3-(Pyridin-3-yl)acrylamid.

5. Verfahren zum horizontalen stromlosen Plattieren gemäß Anspruch 1, wobei das Substrat eine Vielzahl von Durchgangslöchern, Durchkontakten oder Kombinationen davon beinhaltet.

6. Verfahren zum horizontalen stromlosen Plattieren gemäß Anspruch 1, wobei die anorganischen Säuren aus Schwefelsäure oder Salpetersäure ausgewählt sind.

## Revendications

1. Un procédé de placage autocatalytique horizontal d'un substrat comprenant :
a) le nettoyage et le conditionnement du substrat ; ensuite,
b) la microgravure du substrat ; ensuite,
c) le fait de fournir une composition de pré-trempage acide aqueuse constituée d'un ou de plusieurs composés d'acide dihydroxybenzoïque choisis parmi l'acide 3,5-dihydroxybenzoïque, l'acide 2,4-dihydroxybenzoïque, l'acide 2,5-dihydroxybenzoïque, l'acide 2,6-dihydroxybenzoïque, l'acide 2,4-dihydroxy-6-methylbenzoïque, l'acide 2,3-dihydroxybenzoïque, l'acide 3,4-dihydroxybenzoïque et des sels de sodium de ceux-ci ; de l'eau, et un ou plusieurs composés choisis parmi des hydroxydes de métal alcalin et des acides inorganiques afin de maintenir un pH de la composition de pré-trempage acide aqueuse de 2 à 4 ; ensuite,
d) l'application de la composition de pré-trempage acide aqueuse sur le substrat ; ensuite,
e) l'application d'un catalyseur ionique sur le substrat ayant un pH alcalin ; le catalyseur ionique comprenant des complexes d'ions métalliques avec un ou plusieurs composés azotés hétérocycliques, les ions métalliques étant choisis parmi le palladium, le platine ou l'or, et les catalyseurs ioniques étant dépourvus d'étain, d'ions étain et d'antioxydants ; suivi par,
f) l'application d'un agent réducteur sur le substrat avec le catalyseur ionique afin de réduire les ions métalliques du catalyseur ionique jusqu'à un état métallique ; et ensuite,
g) l'application d'un bain de placage au cuivre ou à un alliage de cuivre autocatalytique sur le substrat avec le catalyseur ionique comprenant des ions métalliques réduits jusqu'à l'état métallique afin de plaquer le substrat avec du cuivre ou un alliage de cuivre.

2. Le procédé de placage autocatalytique horizontal de la revendication 1, dans lequel les un ou plusieurs composés azotés hétérocycliques sont un ou plusieurs dérivés de pyrazine choisis parmi la 2,6-diméthylpyrazine, la 2,3-diméthylpyrazine, la 2,5-diméthylpyrazine, la 2,3,5-triméthylpyrazine, la 2-acétylpyrazine, l'aminopyrazine, l'éthylpyrazine, la méthoxypyrazine, la 3,4-diméthylpyrazine et la 2-(2'-hydroxyéthyl)pyrazine.

3. Le procédé de placage autocatalytique horizontal de la revendication 1, dans lequel les un ou plusieurs composés azotés hétérocycliques sont un ou plusieurs dérivés de pyrimidine choisis parmi l'uracile, l'acide barbiturique, l'acide orotique, la thymine, la 2-aminopyrimidine, la 6-hydroxy-2,4-diméthylpyrimidine, le 6-méthyluracile, la 2-hydroxypyrimidine, la 4,6-dichloropyrimidine, la 2,4-diméthoxypyrimidine, la 2-amino-4,6-diméthylpyrimidine, la 2-hydroxy-4,6-diméthylpyrimidine et la 6-méthylisocytosine.

4. Le procédé de placage autocatalytique horizontal de la revendication 1, dans lequel les un ou plusieurs composés azotés hétérocycliques sont un ou plusieurs dérivés de pyridine choisis parmi la 4-diméthylaminopyridine, la 4-aminopyridine, la 2-aminopyridine, la 4-(méthylamino) pyridine, la 2-(méthylamino) pyridine, la 2-amino-4,6-diméthylpyridine, la 2-diméthylamino-4,6-diméthylpyridine, la 4-diéthylaminopyridine, l'acide 2-(pyridin-3-yl) acétique, l'acide 2-amino-3-(pyridin-3-yl) propionique, l'acide 2-amino-3-(pyridin-2-yl) propionique, l'acide 3-(pyridin-3-yl) acrylique, l'acide 3-(4-méthylpyridin-2-yl) acrylique et le 3-(pyridin-3-yl)-acrylamide.

5. Le procédé de placage autocatalytique horizontal de la revendication 1, dans lequel le substrat comprend une pluralité de trous débouchants, de trous de liaison ou de combinaisons de ceux-ci.

6. Le procédé de placage autocatalytique horizontal de la revendication 1, dans lequel les acides inorganiques sont choisis parmi l'acide sulfurique ou l'acide nitrique.
